# EUROPÄISCHE PATENTSCHRIFT

(11) **EP 3 269 015 B1**
(45) Veröffentlichungstag und Bekanntmachung des Hinweises auf die Patenterteilung: **22.07.2020**
(21) Anmeldenummer: 16707418.6
(22) Anmeldetag: 01.03.2016
(51) Int. Cl.: H02G 13/00, G01R 31/08, G01R 31/12

(54) **VERFAHREN ZUR ZUSTANDSBESTIMMUNG UND FEHLERORTUNG AN INSTALLIERTEN ISOLIERTEN ABLEITUNGEN IM ÄUSSEREN BLITZSCHUTZ**
METHOD FOR DETERMINING STATES AND LOCATING FAULTS IN INSTALLED ISOLATED DOWN CONDUCTORS IN THE EXTERNAL LIGHTNING PROTECTION MEANS
PROCÉDÉ DE DÉTERMINATION D'ÉTAT ET DE LOCALISATION DE DÉFAUTS SUR DES DÉRIVATIONS ISOLÉES INSTALLÉES DANS UN SYSTÈME DE PROTECTION EXTÉRIEURE CONTRE LA FOUDRE

(30) Priorität: 11.03.2015 DE 102015003090; 20.07.2015 DE 102015009426
(43) Veröffentlichungstag der Anmeldung: 17.01.2018
(73) Patentinhaber: DEHN SE + Co KG, 92318 Neumarkt / Opf. (DE)
(72) Erfinder: BEIERL, Ottmar, 91086 Aurachtal (DE); BROCKE, Ralph, 98693 Oberpörlitz/Ilmenau (DE); SCHORK, Franz, 90461 Nürnberg (DE)
(74) Vertreter: Kruspig, Volkmar
(86) Internationale Anmeldenummer: PCT/EP2016/054256
(87) Internationale Veröffentlichungsnummer: WO 2016/142205

(56) Entgegenhaltungen:
- EP-A2- 2 518 521
- WO-A1-97/34159
- WO-A1-98/37427
- DE-B3-102013 224 573
- JP-A- H0 484 779
- US-A- 5 767 684

## Beschreibung

Die Erfindung betrifft ein Verfahren zur Zustandsbestimmung und Fehlerortung an installierten isolierten Ableitungen im äußeren Blitzschutz, wobei die isolierten Ableitungen einen koaxialen Aufbau mit metallischem Innenleiter, Dielektrikum und spannungsgesteuertem Außenmantel aus schwachleitendem oder halbleitendem Material besitzen, sowie mit einem Erdanschluss gemäß Oberbegriff des Anspruchs 1.

Isolierte Ableitungen für den äußeren Blitzschutz sind beispielsweise als sogenannte HVI®-Ableitung der Firma DEHN + SÖHNE GmbH + Co. KG vorbekannt.

Beim Anschluss einer isolierten Ableitung an eine Ringleitung oder eine Attika eines Gebäudes ist es funktionsbedingt notwendig, dass die eingesetzte Ableitung im Endverschlussbereich aufgeständert wird, um das für den jeweiligen ausgewiesenen Trennungsabstand erforderliche Isoliervermögen einhalten zu können. Darüber hinaus muss eine gute und ausreichende Standfestigkeit sowie Verlegesicherheit gewährleistet werden. Relevanter Stand der Technik ist in US 5 767 684 A, DE 10 2013 224573 B3 und WO 98/37427 A1 zu finden.

Aus der DE 20 2013 004 927 U1 ist es bekannt, eine isolierte, feldgesteuerte Aufständerung der eigentlichen isolierten Ableitung im Endverschlussbereich zum Einhalten notwendiger Trennungsabstände vorzusehen, wobei ein metallischer Halter als zusätzlicher Potentialausgleich im Endverschlussbereich zur Kontaktierung des halbleitend beschichteten oder halbleitenden Distanzstabs oder Distanzhalters zum Einsatz kommt, der weiterhin am nicht blitzstrombehafteten Potentialausgleich angebunden wird.

Bei dem Verlegen und der Installation derartiger isolierter Ableitungen im äußeren Blitzschutz kann es insbesondere bei nachträglichen Veränderungen der Aufständerung oder Befestigung der isolierten Ableitung zu Beschädigungen, z.B. durch Anbohren, Ansägen, Eindrehen von Schneidschrauben oder dergleichen kommen.

Auf die Anmelderin zurückgehende Untersuchungen bezüglich der Analyse des Zustands vorhandener Installationen isolierter Ableitungen haben ergeben, dass Hochfrequenzmessungen oder Laufzeitverfahren (TDR) nicht geeignet sind, reproduzierbar und exakt Fehlstellen am isolierten Kabel zu ermitteln. Die Hauptproblematik besteht darin, dass eine erfolgreiche Ortung der Fehlerstelle fehlschlägt, da isolierte Ableitungen funktionsbedingt einen halbleitfähigen Mantel aufweisen, dessen Widerstand typischerweise im Bereich von 100 Ohm bis 10 kOhm liegt. Dieser hohe Widerstandswert führt zu großen Dämpfungen des reflektierten Hochfrequenzsignals, so dass eine Fehlerortung problematisch ist. Aufgrund des halbleitenden äußeren Mantels von isolierten Blitzschutzsystemen sind an sich bekannte Kabeldetektionsverfahren z.B. auf Reflexionsbasis nicht zielführend und ungeeignet.

Aus dem Vorgenannten ist es daher Aufgabe der Erfindung, ein weiterentwickeltes Verfahren zur Zustandsbestimmung und Fehlerortung an installierten isolierten Ableitungen im äußeren Blitzschutz anzugeben, wobei die isolierten Ableitungen einen koaxialen Aufbau mit metallischem Innenleiter, Dielektrikum und spannungsgesteuertem Außenmantel besitzen. Weiterhin weist die isolierte Ableitung einen Erdanschluss auf.

Erfindungsgemäß wird zum Zweck der Fehlerortung nach Entfernen des Erdanschlusses eine Impulsspannung in ausreichender Höhe zwischen dem Innenleiter und dem Außenmantel der jeweiligen Ableitung angelegt bzw. es wird eine derartige Impulsspannung eingespeist, welche bei Ableitungsfehlern am Fehlerort zu einer elektrischen Entladung führt.

Diese elektrische Entladung wird zur Zustandsbestimmung des jeweiligen Ableiters einer Bewertung unterzogen.

Die aufgrund der Entladung entstehenden geänderten aperiodischen Spannungs- und/oder Stromverläufe über der Zeit des durch den Anschluss der jeweiligen Ableitung an einen Impulsgenerator sich ergebenden Schwingkreises mit seinen durch die Entladung geänderten Eigenschaften werden zur Zustandsbestimmung erfindungsgemäß herangezogen.

Damit lässt sich zu Wartungs- und Revisionsgründen das aktuelle Isoliervermögen eines derartigen isolierten Kabels bzw. einer entsprechenden isolierten Ableitung im eingebauten Zustand bewerten, d.h. eventuelle Durchschlagstellen werden sicher detektiert.

Dabei wird das Grundprinzip der Auswertung von sich verändernden Schwingkreisparametern durch Strom- und/oder Spannungsmessung an der Einspeisestelle der Impulsspannung am Erdanschluss des hochspannungsfesten Kabels genutzt. Die Impulsspannung wird von einem Generator bereitgestellt, der ausgangsseitig eine Längs-Kopplungsinduktivität besitzt, über die die gewünschte elektrische Verbindung zur isolierten Ableitung hergestellt wird. Durch diese Längs-Induktivität lässt sich das Schwingkreisverhalten in weiten Grenzen beeinflussen. Zur Zustandsbestimmung wird demnach die Impulsantwort des zu untersuchenden Systems der installierten äußeren Ableitung herangezogen, die sich als eine Veränderung des Schwingkreisverhaltens im Vergleich zu einem ungestörten Referenzfall zeigt.

Diesbezüglich kann in Weiterbildung der Erfindung nach Erstinstallation der jeweiligen Ableitung eine Referenzmessung durchgeführt werden, wobei diese Referenzmessung für spätere Zustandsbestimmungen der betreffenden Ableitung gespeichert und herangezogen wird.

Bei einer Alternative besteht die Möglichkeit, die zur Fehlertriggerung eingesetzte Impulsspannung so zu wählen, dass ein erster und ein zweiter Impulsspannungswert vom Impulsspannungsgenerator bereitstellbar ist.

Beim ersten Wert der Impulsspannung wird noch keine Entladung erzeugt und das sich ergebende Schwingkreisverhalten bzw. die Impulsantwort als Referenzgröße herangezogen. Der zweite Wert der Impulsspannung, der wesentlich höher als der Wert der ersten Impulsspannung ist, führt dann zu einer potentiellen Entladung im Fehlerfall. Das sich hierbei ergebende Schwingkreisverhalten wird dann mit dem Schwingkreisverhalten im Referenzfall verglichen und hieraus auf den Zustand der installierten äußeren Ableitung geschlussfolgert.

Zur Zustandsbestimmung wird also der Strom- und/oder Spannungsverlauf mit anliegender Impulsspannung durch geeignete Messmittel erfasst.

Zur Zustandsbestimmung kann ebenso das Flächenintegral des Strom- und/oder Spannungsverlaufs und eine Veränderung dieses mit Anlegen der Impulsspannung herangezogen werden.

Die Erfindung soll nachstehend anhand eines Ausführungsbeispiels sowie unter Zuhilfenahme von Figuren näher erläutert werden.

Hierbei zeigen:
- Fig. 1: eine beispielhafte Imputsgeneratorschaltung zur Bereitstellung und Einspeisung der zur Zustandsbestimmung herangezogenen Impulsspannung;
- Fig. 2: ein vereinfachtes Ersatzschaltbild des isolierten Blitzschutzsystems mit isolierter Ableitung und angedeutetem Fehlerort, symbolisiert durch eine Entladung als Schließvorgang eines Schalters S;
- Fig. 3: einen beispielhaften U/t-Verlauf mit durchgezogener Linie im Fall einer störungsbedingten Entladung und gestrichelter Linie bei einem Verlauf ohne Entladung mit dem Beginn der Entladung symbolisiert durch E und
- Fig. 4: einen beispielhaften I/t-Verlauf mit einer durchgezogenen Linie, die das Verhalten des Schwingkreises im Fehlerfall mit Entladung zeigt, und einer gestrichelten Linie, die das Schwingkreisverhalten ohne fehlerbedingte Entladung repräsentiert.

Zur Sicherstellung erforderlicher Trennungsabstände bei Blitzschutzsystemen ist es bekannt, hochspannungsisolierte Spezialkabel, sogenannte isolierte Ableitungen zu verwenden. Derartige Kabel weisen einen stromtragfähigen Innenleiter, eine ausreichend dimensionierte Isolierung sowie einen schwachleitenden oder halbleitenden äußeren Mantel auf.

Bei längerem Betrieb derartiger Anlagen, aber auch bei der Inbetriebnahme selbst ist es wünschenswert, das Isoliervermögen der isolierten Ableitung im eingebauten Zustand zu bewerten und mögliche Durchschlagstellen, d.h. Fehlerorte sicher zu detektieren.

Diesbezüglich wird vorgeschlagen, eine Auswertung von sich verändernden Schwingkreisparametern durch Strom- und/oder Spannungsmessung an der Einspeisestelle der Impulsspannung am Erdanschluss vorzunehmen.

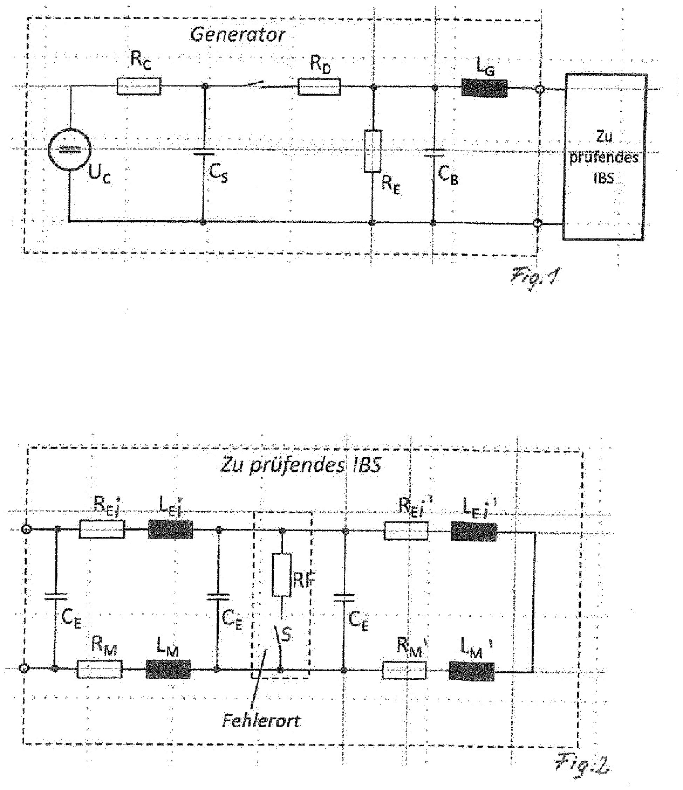

Fig. 1 zeigt eine typische Generatorschaltung zum Erzeugen einer diesbezüglichen Impulsspannung. Die Generatorschaltung wurde um eine Längs-Induktivität L_{G} ergänzt.

Durch eine Wahl der einzelnen Generatorelemente und insbesondere der Parameter der Induktivität L_{G} lässt sich das Schwingkreisverhalten, welches sich bei einem angeschlossenen, zu überprüfenden isolierten Blitzschutzsystem IBS ergibt, in weiten Grenzen beeinflussen. Es ist beispielsweise ein Schwingkreisverhalten im Sinne einer gedämpften Schwingung, eines aperiodischen Verhaltens oder dergleichen realisierbar. Zur Zustandsbestimmung wird die Impulsantwort des zu untersuchenden Systems, d.h. der angeschlossenen Einheit IBS bewertet.

Diesbezüglich sei unter Hinweis auf Fig. 2 auf ein vereinfachtes Ersatzschaltbild eines isolierten Blitzschutzsystems IBS verwiesen.

Die Fehlerstelle, an der sich bei einer Impulsspannung ausreichender Höhe eine Entladung ergibt (Fehlerort), ist durch den Schalter S symbolisiert.

Eine Entladung entspricht hier einem Schließvorgang des Schalters.

Durch die Entladung werden zu den Ersatzschaltbildelementen C_{E}, R_{Ei} sowie L_{Ei} bzw. R_{M} und L_{M} das Element RF und eine entsprechende Induktivität zugeschalten. Dies führt zu typischen Änderungen im Schwingverhalten des sich nun ergebenden Kreises. Diese Veränderungen werden als Auswertekriterium zur Fehlerdetektion erfindungsgemäß herangezogen.

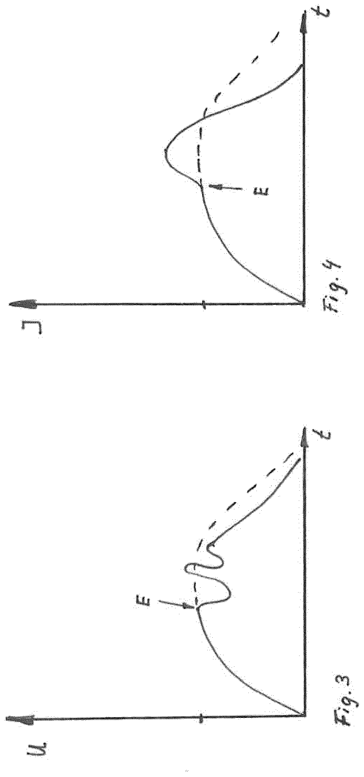

Betrachtet man hier die Kurvenverläufe nach Fig. 3, ist zunächst ersichtlich, dass bei einer fehlerfreien isolierten Ableitung sich ein typischer aperiodischer Fall und ein entsprechender Kurvenverlauf einstellen (gestrichelte Darstellung). Kommt es bei einer definierten Impulsspannung zu einer Entladung E, findet ein Übergang zum gedämpften Schwingfall, dargestellt mittels durchgezogener Linie, statt.

Grundsätzlich andere Fallübergänge sind durch die Auswahl der Eigenschaften des Generators in Verbindung mit der erwähnten Längs-Induktivität L_{G} realisierbar.

Der festgestellte Fallübergang gilt dann als Auswertekriterium für ein defektes Kabel.

Die Fig. 4 zeigt ähnlich wie die Fig. 3 eine Veränderung des Schwingverhaltens, am Beispiel einer Veränderung des Stromverlaufs über der Zeit. An der Stelle E findet eine Entladung aufgrund eines Isolationsfehlers statt und es kommt zu einem Übergang von einem aperiodischen Fall zu einem aperiodischen Grenzfall. Auch dieser Fallübergang wird als Auswertekriterium für ein defektes Kabel herangezogen. Die Stromüberhöhung im Verlauf nach Fig. 4 ergibt sich wie folgt. Der Schwingstrom wird aus der Generatorkapazität C_{S} gespeist, die sich zunächst nur über R_{D} und R_{E} des Generators bzw. R_{EI} und R_{M} des zu prüfenden Kabels entlädt. Kommt es zu einem Durchschlag, verringert sich R_{M} schlagartig, da nur noch ein Teil des Mantelwiderstands wirksam ist, wodurch der Strom I ansteigt.

Eine weitere Auswertemöglichkeit liegt in einer integralen Betrachtung des gesamten Kurvenverlaufs, da ein eintretender Fallübergang auch die unter der Kurve befindliche Fläche beeinflusst bzw. umfasst. Hierdurch ergibt sich ein besonders vorteilhaftes Auswertekriterium, da einfachere Messprinzipien, z.B. ∫ idt bzw. J udt möglich sind.

Prinzipiell genügt es, eine Spannungs- oder Strommessung allein durchzuführen, da beide sich aufgrund der Messung ergebenden Kurvenverläufe dieselben signifikanten Informationen bezüglich der Eigenschaften des jeweiligen Systems enthalten. Kombiniert man Spannungs- und Strommessung, lässt sich eine weitere Erhöhung der Aussagefähigkeit bezogen auf die Qualitäts- oder Zustandskriterien der isolierten Ableitung schaffen.

Ergänzend ist es möglich, Referenzmessungen mit kleiner Impulsspannung durchzuführen, bei der es noch nicht zu Entladungen kommt. Mit dieser Referenzmessung können die Schwingkreisparameter, die ohne Entladung gegeben sind, sicher bestimmt und eingestellt werden.

Wenn dann am selben System die Messung mit gleichen Schwingkreisparametern bei höherer Spannung durchgeführt wird, die zu potentiellen Entladungen im Fehlerfall führt, können Unterschiede im Schwingkreisverhalten leicht erkannt und zur Zustandsbewertung genutzt werden. Aufgrund dieser Möglichkeit der Referenzmessung kann eine Anwendung des Verfahrens bei beliebigen Topologien von isolierten Blitzschutzsystemen vor Ort ohne aufwendige Einstell- und womöglich vorherige Dokumentationsarbeiten vorgenommen werden.

## Patentansprüche

1. Verfahren zur Zustandsbestimmung und Fehlerortung an installierten isolierten Ableitungen im äußeren Blitzschutz (IBS), wobei die isolierten Ableitungen einen koaxialen Aufbau mit metallischem Innenleiter, Dielektrikum und spannungsgesteuertem Außenmantel aus schwachleitendem oder halbleitendem Material besitzen, sowie mit einem Erdanschluss,
**dadurch gekennzeichnet, dass**
zum Zweck der Fehlerortung nach Entfernung des Erdanschlusses mittels eines Impulsgenerators eine Impulsspannung zwischen dem Innenleiter und dem Außenmantel der jeweiligen Ableitung angelegt wird, welche bei Ableitungsfehlern am Fehlerort zu einer Entladung (E) führt, wobei die Entladung (E) oder deren Auswirkungen zur Zustandsbestimmung der jeweiligen Ableitung einer Bewertung unterzogen wird und hierfür die Impulsantwort herangezogen wird, die sich als eine Veränderung des Schwingkreisverhaltens des durch den Anschluss der jeweiligen Ableitung an den Impulsgenerator sich ergebenden Schwingkreises zeigt,
wobei die aufgrund der Entladung (E) entstehenden geänderten aperiodischen Strom- und/oder Spannungsverläufe erfasst werden.

2. Verfahren nach Anspruch 1,
**dadurch gekennzeichnet, dass**
die zur Fehlertriggerung eingesetzte Impulsspannung einen ersten und einen zweiten Wert aufweist derart, dass bei dem ersten Wert noch keine Entladung erzeugbar ist und dass das Schwingkreisverhalten bei diesem ersten Wert als Referenzmessung herangezogen wird und der zweite Wert eine höhere Spannung ist, welche eine potentielle Entladung zur Folge hat.

3. Verfahren nach Anspruch 2,
**dadurch gekennzeichnet, dass**
nach Erstinstallation der jeweiligen Ableitung eine Referenzmessung durchgeführt wird, wobei diese Referenzmessung für spätere Zustandsbestimmungen der betreffenden Ableitung gespeichert und herangezogen wird.

4. Verfahren nach einem der vorangegangenen Ansprüche,
**dadurch gekennzeichnet, dass**
zur Zustandsbestimmung der Strom- und/oder Spannungsverlauf mit Anlegen der Impulsspannung erfasst wird.

5. Verfahren nach einem der vorangegangenen Ansprüche,
**dadurch gekennzeichnet, dass**
zur Zustandsbestimmung das Flächenintegral des Strom- und/oder Spannungsverlaufs und Veränderungen dieses mit Anlegen der Impulsspannung herangezogen wird.

## Claims

1. A method for determining states and locating faults in installed isolated down conductors in the external lightning protection means (IBS), wherein the isolated down conductors have a coaxial structure with a metal inner conductor, dielectric medium and voltage-controlled outer casing made of weakly conducting or semi-conducting material as well as having an earth connection,
**characterized in that**
for the purpose of locating faults, after removal of the earth connection, a pulse voltage is applied between the inner conductor and the outer casing of the respective down conductor which leads to a discharge (E) in case of down conductor faults at the fault location, wherein the discharge (E) or the effects thereof are subjected to an evaluation for state determination of the respective down conductor and to this end, the pulse response is used, which appears as a change of the resonant circuit behavior of the oscillating circuit resulting from the connection of the respective down conductor to the pulse generator, wherein the changed aperiodic current and/or voltage curves which are generated due to the discharge (E) are detected.

2. The method according to claim 1,
**characterized in that**
the pulse voltage employed for fault triggering comprises a first and a second value such that at the first value, a discharge cannot yet be generated, and that the oscillating circuit behavior at this first value is used as a reference measurement, and the second value is a higher voltage entailing a potential discharge.

3. The method according to claim 2,
**characterized in that**
a reference measurement is performed after the initial installation of the respective down conductor, wherein this reference measurement is stored and used for later state determinations of the respective down conductor.

4. The method according to any one of the preceding claims,
**characterized in that**
for state determination, the current and/or voltage curve is detected while applying the pulse voltage.

5. The method according to any one of the preceding claims,
**characterized in that**
for state determination, the surface integral of the current and/or voltage curve and changes thereof while applying the pulse voltage are used.

## Revendications

1. Procédé de détermination de l'état et de localisation de défauts sur des conducteurs de descente isolés installés dans une protection externe contre la foudre (IBS), les conducteurs de descente isolés ayant une structure coaxiale avec un conducteur intérieur métallique, un diélectrique et une gaine extérieure à tension contrôlée en matériau peu conducteur ou semi-conducteur, et ayant une connexion à la terre,
**caractérisé en ce que**
pour la localisation du défaut après enlèvement de la connexion à la terre, une tension d'impulsion est appliquée entre le conducteur intérieur et la gaine extérieure du conducteur de descente respectif au moyen d'un générateur d'impulsions, laquelle tension entraîne une décharge (E) à l'endroit du défaut, en cas de défauts du conducteur de descente, la décharge (E) ou ses effets étant soumis à une évaluation afin de déterminer l'état du conducteur de descente respectif, et la réponse impulsionnelle est utilisée à cet effet, laquelle réponse s'exprime par une modification du comportement du circuit oscillant résultant de la connexion du conducteur de descente respectif au générateur d'impulsions, et
les évolutions de courant et/ou de tension modifiées apériodiques résultant de la décharge (E) sont enregistrées.

2. Procédé selon la revendication 1,
**caractérisé en ce que**
la tension d'impulsion utilisée pour le déclenchement du défaut présente une première et une deuxième valeur, de telle sorte qu'aucune décharge ne peut encore être générée à la première valeur et que le comportement du circuit oscillant à cette première valeur est utilisé comme mesure de référence et la deuxième valeur est une tension plus élevée qui entraîne une décharge potentielle.

3. Procédé selon la revendication 2,
**caractérisé en ce que**
une mesure de référence est effectuée après l'installation initiale du conducteur de descente respectif, cette mesure de référence étant stockée et utilisée pour les déterminations ultérieures de l'état du conducteur de descente respectif.

4. Procédé selon l'une des revendications précédentes,
**caractérisé en ce que**
pour déterminer l'état, l'évolution du courant et/ou de la tension est enregistrée avec application de la tension d'impulsion.

5. Procédé selon l'une des revendications précédentes,
**caractérisé en ce que**
pour déterminer l'état, l'intégrale de surface de l'évolution de courant et/ou de tension et les modifications de celle-ci sont utilisées avec application de la tension d'impulsion.
